(19) Europäisches Patentamt
European Patent Office
Office européen des brevets

(11) **EP 2 564 183 B1**

(12) **EUROPÄISCHE PATENTSCHRIFT**

(45) Veröffentlichungstag und Bekanntmachung des Hinweises auf die Patenterteilung:
**01.12.2021 Patentblatt 2021/48**

(51) Int Cl.:
*G01R 31/265* (2006.01)    *G01N 21/64* (2006.01)
*G01R 31/26* (2020.01)

(21) Anmeldenummer: **11715660.4**

(22) Anmeldetag: **13.04.2011**

(86) Internationale Anmeldenummer:
**PCT/EP2011/001848**

(87) Internationale Veröffentlichungsnummer:
**WO 2011/134602 (03.11.2011 Gazette 2011/44)**

(54) **VERFAHREN ZUR BESTIMMUNG VON MATERIALPARAMETERN EINES DOTIERTEN HALBLEITERSUBSTRATES DURCH MESSUNG VON PHOTOLUMINESZENZSTRAHLUNG**

METHOD FOR DETERMINING MATERIAL PARAMETERS OF A DOPED SEMICONDUCTOR SUBSTRATE BY MEASURING PHOTOLUMINESCENT RADIATION

PROCÉDÉ DE DÉTERMINATION DE PARAMÈTRES DE MATÉRIAU D'UN SUBSTRAT SEMI-CONDUCTEUR DOPÉ PAR LA MESURE DU RAYONNEMENT PHOTOLUMINESCENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.04.2010 DE 102010019132**

(43) Veröffentlichungstag der Anmeldung:
**06.03.2013 Patentblatt 2013/10**

(73) Patentinhaber: **Fraunhofer-Gesellschaft zur Förderung der angewandten Forschung e.V.
80686 München (DE)**

(72) Erfinder: **GIESECKE, Johannes
79102 Freiburg (DE)**

(74) Vertreter: **Lemcke, Brommer & Partner Patentanwälte Partnerschaft mbB
Siegfried-Kühn-Straße 4
76135 Karlsruhe (DE)**

(56) Entgegenhaltungen:
WO-A1-2008/037002    WO-A1-2008/052237
DE-A1-102008 044 879    US-A- 4 661 770

- **BRUGGEMANN R ET AL: "Modulated photoluminescence studies for lifetime determination in amorphous-silicon passivated crystalline-silicon wafers", JOURNAL OF NON-CRYSTALLINE SOLIDS, NORTH-HOLLAND PHYSICS PUBLISHING. AMSTERDAM, NL, Bd. 352, Nr. 9-20, 15. Juni 2006 (2006-06-15), Seiten 1888-1891, XP025187692, ISSN: 0022-3093, DOI: DOI:10.1016/J.JNONCRYSOL.2005.11.092 [gefunden am 2006-06-15]**
- **Trupke T et al: "Effective Excess Carrier Lifetimes Exceeding 100 Milliseconds in Float Zone Silicon Determined From Photoluminescence", , Juni 2004 (2004-06), Seiten 1-4, XP002653095, Gefunden im Internet: URL:http://www.btimaging.com/Pdfs/Q1%20Ult rahigh%20lifetime%20determined%20from%20P L %20EPVSC%20Paris%202004.pdf [gefunden am 2011-07-25]**
- **ALTERMATT P ET AL: "Injection dependence of spontaneous radiative recombination in crystalline silicon: Experimental verification and theoretical analysis", APPLIED PHYSICS LETTERS, AIP, AMERICAN INSTITUTE OF PHYSICS, MELVILLE, NY, US, Bd. 88, Nr. 26, 26. Juni 2006 (2006-06-26) , Seiten 261901-261903, XP012082304, ISSN: 0003-6951, DOI: DOI:10.1063/1.2218041**
- **None**

**Beschreibung**

Die Erfindung betrifft ein Verfahren zur Bestimmung von Materialparametern eines dotierten Halbleitersubstrates durch Messung von Photolumineszenzstrahlung.

Bei dotierten Halbleitersubstraten, insbesondere bei Siliziumwafern ist es bekannt, anhand einer in der Halbleiterstruktur erzeugten Lumineszenzstrahlung und deren Messung Aufschluss über Materialparameter des Halbleitersubstrates zu erlangen. Insbesondere werden Messungen der Lumineszenzstrahlung dazu verwendet, Kenntnis über die Materialqualität hinsichtlich der effektiven Lebensdauer der Minoritätsladungsträger oder der hierzu korrespondierenden effektiven Diffusionslänge zu erlangen.

Hierbei ist es bekannt, die Diffusionslänge/Lebensdauer des Halbleitermaterials aus der Messung der Lumineszenzstrahlung zu bestimmen. Entsprechende Vorgehensweisen sind in der Literatur beschrieben, beispielsweise in Würfel, P. et al, "Diffusions lengths of silicon solar cells from luminescence images", Journal of Applied Physics, 101: 123110, 2007, oder in Trupke, T. et al, "Photoluminescence imaging of silicon wafers", Applied Physics Letters, 89: 044107, 2006 und WO 2008/052237.

Weiterhin sind Messmethoden bekannt, bei denen die Beaufschlagung des Halbleitersubstrates mit modulierter Anregungsstrahlung erfolgt, so dass die durch die Anregungsstrahlung bedingte Generationsrate G von Ladungsträgerpaaren in dem Halbleitersubstrat zeitlich inhomogen ist und mindestens ein Maximum aufweist. Typischerweise wird eine periodische, sinusartige Modulation verwendet. Hierbei erfolgt die Modulation derart, dass ein quasi statischer Zustand erreicht wird. Die entsprechende Messmethode mit Auswertung der Photolumineszenzstrahlung ist als quasi statische Photolumineszenz-Lebensdauermessung (quasi-steady-state photoluminescence life time measurements, QSS-PL) bekannt und beispielsweise in T. Trupke and R. A. Bardos, 31 st IEEE PVSC, Orlando, 2005 beschrieben.

Bei den quasi statischen Photolumineszenz-Messmethoden ist die quantitative Ermittlung der Überschussladungsträgerdichte $\Delta n$ zur Bestimmung beispielsweise der effektiven Lebensdauer $\tau$ der Minoritätsladungsträger wesentlich. Zur Kalibrierung der quasi-statischen Photolumineszenz-Messmethoden ist es bekannt, mittels einer Selbstkonsistenz-Methode entsprechende Kalibrierparameter zu ermitteln, wie beispielsweise in T. Trupke, R.A. Bardos, M.D. Abbott, "Self-Consistent Calibration of Photoluminescence and Photoconductance Lifetime Measurements", Applied Physics Letters, 87: 184102, 2005 beschrieben.

Bei dieser selbstkonsistenten Kalibrierung ist Kenntnis der Konzentration elektrisch aktiver Dotieratome $N$ im Halbleitersubstrat (im Folgenden vereinfachend als Dotierkonzentration bezeichnet) sowie der zeitabhängigen Generationsrate $G(t)$ während der Beaufschlagung des Halbeitersubstrates mit modulierter Anregungsstrahlung jeweils quantitativ notwendig. Hierbei ist insbesondere die Bestimmung der Dotierkonzentration N mit konventionell verwendeten Methoden (wie etwa einer wirbelstrombasierten Messmethode, vgl. Sinton, R. et al, "Quasi-Steady-State Photoconductance, a new method for solar cell material and device characterization", 25th IEEE PVSC, Washington D.C., 1996) problematisch. Gegenwärtig setzt sich die Erkenntnis in der einschlägigen Literatur durch, dass in vielen neuen Materialien zur Solarzellenproduktion wie beispielsweise auch in multikristallinem Silicium konventionelle Methoden zur Bestimmung der Dotierkonzentration N an ihre Grenzen stoßen, da sie präzise quantitative Annahmen über die Mobilität der Ladungsträger voraussetzen, die man dort so nicht treffen kann (vgl. Cuevas, A. "The paradox of compensated silicon", COMMAD IUMRS-ICEM08, Sydney, 2008).

Aus Bruggemann R et al: "Modulated photoluminescence studies for lifetime determination in amorphoussilicon passivated crystalline-silicon wafers", DOI:10.1016/J.JNONCRYSOL.2005.11.092 ist ein Verfahren zur Bestimmung von Materialparametern eines dotierten Halbleitersubstrates bekannt, bei welchem mittels Messungen der Lumineszenzstrahlung Kenntnis über die Materialqualität hinsichtlich der effektiven Lebensdauer der Minoritätsladungsträger erlangt wird.

Der hier beschriebenen Erfindung liegt daher die Aufgabe zugrunde, eine auf Photolumineszenz basierende, von bisher notwendigen Annahmen über Ladungsträgermobilitäten unabhängige Methode zur Messung von Minoritätsladungsträgerlebensdauern zu schaffen, insbesondere, eine von der im Allgemeinen für auf Photolumineszenz basierende Lebensdauermessungen zusätzlich notwendige Bestimmung der Dotierkonzentration N unabhängige Methode zu schaffen.

Gelöst ist diese Aufgabe durch ein Messverfahren gemäß Anspruch 1 und ein Messverfahren gemäß Anspruch 2. Vorteilhafte Ausgestaltungen der Messverfahren finden sich in den Ansprüchen 3 bis 7.

Das dotierte Halbleitersubstrat wird in einem Verfahrensschritt A mit elektromagnetischer Anregungsstrahlung zum Erzeugen von Lumineszenzstrahlung in dem Halbleitersubstrat beaufschlagt, wobei der zeitliche Verlauf der Intensität der Anregungsstrahlung moduliert ist. Die periodische Modulation erfolgt derart, dass die Generationsrate G von Ladungsträgerpaaren in dem Halbleitersubstrat aufgrund der Anregungsstrahlung während einer Anregungsperiode ein Maximum und ein Minimum aufweist. Weiterhin wird der zeitliche Verlauf der Generationsrate $G(t)$ mittels zeitabhängiger Messung der Intensität der Anregungsstrahlung bestimmt.

In Verfahrensschritt B erfolgt eine zeitaufgelöste Messung zumindest der relativen Intensität der von einem Messbereich des Halbleitersubstrates ausgehenden Lumineszenzstrahlung, wobei der zeitliche Verlauf der Intensität

der Lumineszenzstrahlung $\Phi(t)$ zumindest während einer Anregungsperiode der Anregungsstrahlung gemessen wird.

In einem Verfahrensschritt C wird mindestens ein Materialparameter des Halbleitersubstrates abhängig von dem zeitlichen Verlauf $G(t)$ der Generationsrate und dem zeitlichen Verlauf der Intensität der Lumineszenzstrahlung $\Phi(t)$ bestimmt.

Wesentlich ist, dass in Schritt C die effektive Lebensdauer $\tau$ der Minoritätsladungsträger des Halbleitersubstrates zumindest bei der während einer Anregungsperiode maximal erreichten Überschussladungsträgerdichte $\Delta n_{max}$ ermittelt wird, in dem die zeitliche Differenz zwischen dem Maximum von $G(t)$ und einem hierzu korrespondierenden Maximum von $\Phi(t)$ bestimmt wird.

Der Erfindung liegt die Erkenntnis des Anmelders zugrunde, dass im Spezialfall injektionsunabhängiger Lebensdauer in überraschend einfacher Weise die effektive Lebensdauer des Halbleitersubstrates ermittelt werden kann, sofern die o.g. Bedingung eines quasi-statischen Messverfahrens erfüllt ist:

Die Modulation der Anregungsstrahlung führt zu einer entsprechenden Modulation der Generationsrate $G(t)$ von Ladungsträgerpaaren in dem Halbleitersubstrat. Die zeitabhängig gemessene Lumineszenzstrahlung $\Phi(t)$ weist entsprechend ebenfalls mindestens ein Maximum hinsichtlich der Intensität auf. Das Maximum der Intensität der Lumineszenzstrahlung liegt jedoch zeitversetzt etwas später gegenüber dem Maximum der Generationsrate $G(t)$. Bei dem erfindungsgemäßen Verfahren wird dieser Zeitversatz bestimmt. Dieser Zeitversatz entspricht im Spezialfall injektionsunabhängiger Lebensdauer der effektiven Lebensdauer in dem Halbleitersubstrat.

Vorzugsweise erfolgt in Schritt A die periodische Modulation derart, dass der das Minimum der Generationsrate G weniger als 50%, vorzugsweise weniger als 20% im Besonderen weniger als 10% des Maximums der Generationsrate beträgt. Hierdurch ist eine hohe Genauigkeit der Lebensdauerbestimmung gewährleistet.

Vorzugsweise erfolgt in Schritt A die Modulation der Generationsrate sinusartig, da sich hierdurch eine vergleichsweise einfache mathematischen Behandlung ergibt.

Vorzugsweise wird bei der periodischen Modulation die Periodendauer T größer als die zu erwartende Lebensdauer gewählt, insbesondere mindestens um einen Faktor 30, im Weiteren mindestens um einen Faktor 50, bevorzugt um mindestens einen Faktor 100 größer. Hierdurch ist das Vorliegen quasi-statischer Messbedingungen gewährleistet.

Es ist bekannt, dass die effektive Lebensdauer i.d.R. abhängig von der in dem Halbleitersubstrat vorliegenden Überschussladungsträgerdichte $\Delta n$ ist. Durch diese Abhängigkeit wird auch der Zeitversatz zwischen den Maxima von Generationsrate und Photolumineszenz-Intensität beeinflusst, sodass er nicht mehr mit der Lebensdauer identifiziert werden kann, bzw. zu einem Fehler bei der Bestimmung führt.

Durch eine Erweiterung der Verfahrensschritte A, B und C kann in der folgenden vorzugsweisen Ausführungsform des Verfahrens dennoch eine genaue Lebensdauerbestimmung auf der Basis der Messung des Zeitversatzes zwischen den Maxima von Generationsrate und Intensität der Photolumineszenzstrahlung durchgeführt werden. Dazu wird vorzugsweise ein Iterationsverfahren angewendet, um die zur während einer Anregungsperiode maximal erreichten Überschussladungsträgerdichte gehörige Lebensdauer $\tau_0 = \tau(\Delta n_{max})$ zu bestimmen.

Verfahrensschritte A und B werden dazu vorzugsweise dahingehend erweitert, dass die Beaufschlagung mit Anregungsstrahlung, die Messung der Generationsrate, sowie die Messung der Intensität der Photolumineszenzstrahlung bei mindestens jeweils zwei geringfügig verschiedenen maximalen Anregungsintensitäten erfolgen. Diese unterscheiden sich relativ vorzugsweise im Bereich zwischen 5% und 25%, bevorzugt im Bereich zwischen 10% und 20%, im Weiteren bevorzugt um etwa 15%.

Es erfolgt somit zumindest eine zweimalige Ausführung der Verfahrensschritt A und B, wobei sich die erste und die zweite Ausführung hinsichtlich der maximalen Anregungsintensitäten unterscheiden.

In Verfahrensschritt C werden die berechneten Zeitversätze der jeweiligen Maxima von Generationsrate und Photolumineszenz-Intensität bei den verschiedenen Anregungsbedingungen verwendet. Die Bestimmung der Materialparameter erfolgt hierbei vorzugsweise über ein Iterationsverfahren.

Die Bestimmung der zur während einer Anregungsperiode maximal erreichten Überschussladungsträgerdichte gehörigen Lebensdauer erfolgt vorzugsweise mittels des vorgenannten Iterationsverfahrens und vorzugsweise abhängig von den mindestens zwei unter den verschiedenen Anregungsbedingungen bestimmten Zeitversätzen zwischen dem jeweiligen Maximum der Generationsrate und der Intensität der Anregungsstrahlung.

Besagtes Iterationsverfahren wird dazu verwendet, um die injektionsabhängige Lebensdauer $\tau(\Delta n)$ zu finden, die - eingesetzt in die die Ladungsträgerdynamik beschreibende Differentialgleichung (siehe Gleichung 4) - die gemessenen zeitlichen Differenzen der Maxima von $G(t)$ und $\Phi(t)$ jeweils korrekt abbildet.

Das Iterationsverfahren zur Bestimmung der Lebensdauer ist vorzugsweise wie folgt ausgebildet:

Die zu den beiden Messungen mit jeweils geringfügig unterschiedlichen Anregungsintensitäten gemessenen Zeitverschiebungen zwischen den Maxima von Generationsrate und Intensität der Photolumineszenzstrahlung seien hier mit $\Delta t_{0,i}$, die zugehörigen maximalen Generationsraten mit $G_{0,i}$ bezeichnet. Der Index $j$ indiziert im Folgenden den jeweiligen Iterationsschritt, der Index $i$ indiziert die verschiedenen Anregungsintensitäten. In einem Initialschritt ($j=1$) wird angenommen, die gemessenen Zeitverschiebungen $\Delta t_{0,i}$ entsprächen Lebensdauern $\tau_{1,i} = \Delta t_{0,i}$. Die zugehörigen Überschussladungsträgerdichten wären dann $\Delta n_{1,i} = \tau_{1,i} G_{0,i}$. Die $\tau_{1,i}(\Delta n_{1,i})$ werden dann für eine Approximation, vorzugsweise eine lineare Approximation, der injektionsabhängigen Lebensdauer $\tau(\Delta n)$ in die die Ladungsträgerdynamik beschreibende Differentialgleichung (Gleichung 4) eingesetzt, um aus deren numerischer Lösung wiederum Zeitverschiebungen $\Delta t_{1,i}$ zu berechnen. Eine Korrektur der Lebensdauer ergibt sich dann folgendermaßen:

$$\tau_{j+1,i} = \tau_{j,i} + \varepsilon \left( \Delta t_{0,i} - \Delta t_{j,i} \right) \qquad (1)$$

Dieses Verfahren wird nun wiederholt, bis die Lebensdauer konvergiert, d.h. die Veränderung der Lebensdauer von einem Iterationsschritt zum nächsten vernachlässigbar ist. Dabei wird die Zahl $0 < \varepsilon < 1$ so klein gewählt, dass Konvergenz ermöglicht wird. Typischerweise reichen 10-20 Iterationsschritte aus, um konvergente Lebensdauern zu erreichen.

Zur Bestimmung der effektiven Lebensdauer mit dem erfindungsgemäßen Verfahren ist keine Kenntnis der Dotierkonzentration $N$ des Halbleitersubstrates notwendig.

Mit dem erfindungsgemäßen Verfahren ist somit die Bestimmung der effektiven Lebensdauer $\tau$ des Halbleitersubstrates im Bereich der Überschussladungsträgerdichte $\Delta n_{max}$ möglich.

Wie bereits erwähnt, und wie bei den vorbekannten QSS-PL-Methoden erfolgt auch bei dem erfindungsgemäßen Verfahren eine quasi-statische Messung. Dies bedeutet, dass die Periodendauer der Modulation der Anregungsstrahlung groß gegenüber der effektiven Lebensdauer der Minoritätsladungsträger des Halbleitersubstrates ist.

In einer vorzugsweisen Ausführungsform des erfindungsgemäßen Verfahrens erfolgt in Schritt C die Bestimmung der effektiven Lebensdauer $\tau(\Delta n)$ des Halbleitersubstrates in Abhängigkeit der Überschussladungsträgerdichte $\Delta n$ und/oder die Bestimmung der Dotierkonzentration N des Halbleitersubstrates. Die Bestimmung erfolgt abhängig von dem zumindest qualitativ gemessenen zeitlichen Verlauf $\Phi(t)$ der Intensität der Photolumineszenzstrahlung, dem quantitativ bestimmten zeitlichen Verlauf der Generationsrate $G(t)$ und der gemäß den oben beschriebenen Verfahrensschritten bestimmten Lebensdauer $\tau_0 = \tau(\Delta n_{max})$.

Die Bestimmung in dieser vorzugsweisen Ausführungsform des erfindungsgemäßen Verfahrens ist auf der Erkenntnis begründet, dass es bei Kenntnis des quantitativen zeitlichen Verlaufs der Generationsrate $G(t)$ möglich ist, die effektive Lebensdauer $\tau$ in Abhängigkeit der Überschussladungsträgerdichte $\Delta n$, d. h. nicht nur für den unmittelbaren Bereich um die Überschussladungsträgerdichte $\Delta n_{max}$, und ferner die Dotierkonzentration N des Halbleitersubstrates zu bestimmen. Auch in dieser vorzugsweisen Ausführungsform ist somit keine vorherige Kenntnis der Dotierkonzentration $N$ des Halbleitersubstrates notwendig. Darüber hinaus ist es möglich die Dotierkonzentration aus den Messdaten selbst zu bestimmen.

Bei Ausführung des erfindungsgemäßen Verfahrens zur Bestimmung der Dotierkonzentration N erfolgt vorzugsweise in Schritt A die periodische Modulation derart, dass der das Minimum der Generationsrate G weniger als 15%, vorzugsweise weniger als 10% im Besonderen weniger als 5% des Maximums der Generationsrate beträgt. Hierdurch ist eine hohe Genauigkeit der Bestimmung der Dotierkonzentration N gewährleistet.

Die Kenntnis des qualitativen zeitlichen Verlaufs der Intensität der Photolumineszenzstrahlung $\Phi(t)$ und des quantitativen zeitlichen Verlaufs der Generationsrate $G(t)$ zusätzlich zur Kenntnis der Lebensdauer $\tau_0 = \tau(\Delta n_{max})$ aus der zuvor beschriebenen Vorgehensweise ist zur Ermittlung sowohl der injektionsabhängigen Lebensdauer $\tau(\Delta n)$ als auch der Dotierkonzentration $N$ hinreichend. Aus der Krümmung des zeitlichen Verlaufs der Intensität der Photolumineszenzstrahlung $\Phi(t)$ lässt sich (z.B. bei sinusförmiger Anregung) bei quantitativer Kenntnis der Generationsrate am Maximum Go, die Dotierkonzentration des Halbleitersubstrates abhängig von der Krümmung des zeitlichen Verlaufs der relativen (auf ein Maximum von 1 normierten) Intensität der Photolumineszenzstrahlung $\Phi(t)$ am korrespondierenden Maximum am Zeitpunkt $t = t_{max}$ ermitteln. Dies erfolgt vorzugsweise wie folgt:

$$\left. \frac{\partial^2 \Phi'(t)}{\partial t^2} \right|_{t = t_{max}} = -2 \frac{\pi^2}{T^2} \frac{2 G_0 \tau_0 + N}{G_0 \tau_0 + N} \qquad (2)$$

Da alle in dieser Gleichung auftretenden Größen bis auf die Dotierkonzentration $N$ durch die Messung von $G(t)$ und $\Phi(t)$ bekannt sind und zudem der Term $2\pi^2/T^2$ der Krümmung der auf ein Maximum von 1 normierten Generationsrate an deren Maximum entspricht, kann die Gleichung nach $N$ aufgelöst und damit $N$ bestimmt werden.

Vorzugsweise erfolgt hierbei in Schritt C die Beschreibung des zeitlichen Verlaufs der Generationsrate $G(t)$ mittels eines mathematischen Modells, welches einen ersten Satz von mindestens zwei Fitparametern aufweist und die Beschreibung des zeitlichen Verlaufs der Intensität der Photolumineszenzstrahlung $\Phi(t)$ mittels eines dem Ersten analogen mathematischen Modells, welches einen zweiten Satz von mindestens zwei Fitparametern aufweist. Die Bestimmung der Fitparemeter des ersten Satzes erfolgt abhängig von der zeitabhängig gemessenen Intensität der Anregungsstrahlung und entsprechend erfolgt die Bestimmung der Fitparameter des zweiten Satzes abhängig von der zeitabhängig gemessenen Intensität der Photolumineszenzstrahlung.

In dieser vorzugsweisen Ausführungsform liegt somit eine mathematische Beschreibung anhand der bestimmten Fitparameter der zeitabhängigen Generationsrate in dem Halbleitersubstrat in quantitativer Form und der zeitabhängigen Photolumineszenzstrahlung in qualitativer Form vor. Die Bestimmung der effektiven Lebensdauer $\tau$ des Halbleitersubstrates in Abhängigkeit der Überschussladungsträgerdichte $\Delta n$ und/oder die Bestimmung der Dotierkonzentration $N$ des Halbleitersubstrates erfolgt abhängig von dem ersten und dem zweiten Satz Fitparameter.

Vorzugsweise erfolgt hierbei die Modulation der Anregungsstrahlung sinusförmig und das mathematische Modell für den zeitlichen Verlauf der Generationsrate und für den zeitlichen Verlauf der Intensität der Photolumineszenzstrahlung weist vorzugsweise eine sinusartige Funktion und jeweils als Fitparameter eine Frequenz und eine Phasenlage auf.

Die Verwendung sinusförmiger Modulation für die Anregungsstrahlung ist aus den vorbekannten Methoden der QSS-PL-Messung bereits bekannt. Diese Modulation der Anregungsstrahlung führt zu einem mathematisch einfachen Modell für den zeitlichen Verlauf der Intensität der Photolumineszenzstrahlung und der Generationsrate, so dass in einfacher Weise und mit einfachen, vorbekannten mathematischen Fitmethoden eine Bestimmung der genannten Fitparameter möglich ist.

Vorzugsweise erfolgt hierbei die Beschreibung der Generationsrate durch Gleichung 2 mit der maximalen Generationsrate Go, der Periodendauer der sinusförmigen Modulation $T$ und dem Zeitpunkt maximaler Generation $t_0$:

$$G(t) = G_0 \cos^2 \left( \frac{\pi}{T} (t - t_0) \right) \qquad (3)$$

Im Spezialfall quasi-statischer Anregungsbedingungen ($\tau \ll T$) ergibt sich die Überschussladungsträgerdichte im Halbleitersubstrat als Funktion der Zeit als Lösung der zeitabhängigen Kontinuitätsgleichung

$$\frac{\partial \Delta n(t)}{\partial t} + \frac{\Delta n(t)}{\tau(\Delta n(t))} = G(t) \qquad (4)$$

(bei vernachlässigbarer Injektionsabhängigkeit der Lebensdauer zunächst) folgendermaßen:

$$\Delta n(t) = G_0 \tau \cos^2 \left( \frac{\pi}{T} (t - t_0 - \tau) \right). \qquad (5)$$

D.h., die Überschussladungsträgerdichte $\Delta n$ entspricht der um die Lebensdauer zeitlich retardierten und mit der Lebensdauer multiplizierten zeitabhängigen Generationsrate. Mit einem zunächst unbekannten Faktor $A$ und der Dotierkonzentration $N$ lässt sich das Lumineszenzsignal $\Phi(t)$ des Halbleitersubstrats folgendermaßen beschreiben:

$$\Phi(t) = A \cdot \Delta n(t) \cdot (\Delta n(t) + N). \qquad (6)$$

Mit der Phase $\alpha = \pi(t - t_0 - \tau_0)/T$ und der Dotierkonzentration $N$ erfolgt dann die Beschreibung eines zeitabhängigen, relativen (auf ein Maximum von 1 normierten) Photolumineszenzsignals über

$$\Phi'(t) = \frac{G_0 \tau \cos^4 \alpha + N \cos^2 \alpha}{G_0 \tau + N}. \qquad (7)$$

Hieraus lässt sich durch zweimalige Zeitableitung (vgl. Gleichung 2) ein Ausdruck für die Krümmung der relativen Lumineszenzintensität an ihrem Maximum bestimmen, der die Dotierkonzentration enthält. Da $G_0$, $\tau_0$ und $T$ durch zuvor beschriebene Fitmethoden und Vorgehensweisen bereits bekannt sind, ist N die einzige Unbekannte in Gleichung 2 und kann eindeutig bestimmt werden.

Zusätzlich und/oder alternativ lässt sich die effektive Lebensdauer $\tau_{eff}$ abhängig von der Überschussladungsträgerdichte $\Delta n$ wie folgt berechnen: Mit bekannter Dotierkonzentration $N$ und bekannter Lebensdauer bei maximaler Überschussladungsträgerdichte $\tau_0$ sowie bekannter maximaler Generationsrate Go ist auch die maximale Überschussladungsträgerdichte $\Delta n_{max} = G_0 \tau_0$ bekannt. Darüber lässt sich in Gleichung 6 der zunächst noch unbekannte Faktor $A$ bestimmen, was durch Auflösen von Gleichung 6 eine Bestimmung von $\Delta n(t)$ ermöglicht. Die zeitabhängige Überschussladungsträgerdichte kann wiederum in die Kontinuitätsgleichung (Gleichung 4) eingesetzt und diese (da $G(t)$ bekannt ist) nach der Lebnesdauer aufgelöst werden. Damit ist die Lebensdauer als Funktion der Überschussladungsträgerdichte bestimmbar.

Insbesondere zur Bestimmung der Dotierkonzentration N des Halbleitersubstrates ist es vorteilhaft, wenn die maximale Überschussladungsträgerdichte $\Delta n_{max} = G_0 \tau_0$ in etwa der Basisdotierkonzentration entspricht. Vorzugsweise wird die Modulation der Anregungsstrahlung daher - sofern die Größenordnungen von Lebensdauer und Dotierkonzentration etwa bekannt sind - derart gewählt, dass die Überschussladungsträgerdichte bei maximaler Generation in etwa der zu erwartenden Dotierkonzentration entspricht.

Basierend auf einer Erkenntnis des Anmelders ist es unter meist gegebenen Umständen einer signifikanten Abhängigkeit der Minoritätsladungsträger-Lebensdauer von der Überschussladungsträgerdichte notwendig, diese Abhängigkeit auch bei der Berechnung der Dotierkonzentration N gemäß Gleichung 2 mitzubereücksichtigen. Aus den zuvor beschriebenen Verfahrensschritten A, B und C ließ sich entnehmen, dass durch Messung der Generationsrate sowie der Intensität der Photolumineszenzstrahlung bei zwei sich um vorzugsweise ca. 10% unterscheidenden Anregungsintensitäten sowohl die Lebensdauer $\tau_0$ als auch deren Steigung $\gamma$ im unmittelbaren Bereich um die Überschussladungsträgerdichte $\Delta n_{max}$ bestimmen lässt:

$$\tau \approx \tau_0 + \gamma(\Delta n - \tau_0 G_0) \qquad (8)$$

Man kann zeigen, dass sich damit die Krümmung der Photolumineszenzintensität an ihrem Maximum (zum Zeitpunkt $t = t_{max}$) unter Berücksichtigung der Injektionsabhängigkeit der Lebensdauer verhält wie

$$\left.\frac{\partial^2 \Phi'(t)}{\partial t^2}\right|_{t=t_{max}} = -2\frac{\pi^2}{T^2}\frac{2G_0\tau_0 + N}{G_0\tau_0 + N}\frac{1}{1-\gamma G_0}. \qquad (9)$$

Es hat sich erwiesen, dass diese Korrektur in den meisten Fällen notwendig ist, da der Parameter $\gamma$ typischerweise einen starken Einfluss auf die Krümmung der Photolumineszenzintensität an ihrem Maximum hat.

In einer weiteren vorzugsweisen Ausführungsform des erfindungsgemäßen Verfaherns erfolgt die quantitative Bestimmung der Dotierkonzentration N und/oder der effektiven Lebensdauer der Minoritätsladungsträger $\tau(\Delta n)$ abhängig von der Überschussladungsträgerdichte $\Delta n$ durch Durchführung der Verfahrensschritte A und B bei zwei jeweils sehr unterschiedlichen Messbedingungen:

Eine erste Messbedingung ist derart gewählt, dass Niedriginjektionsbedingungen in dem Halbleitersubstrat vorliegen und eine zweite Messbedingung ist derart gewählt, dass Hochinjektionsbedingungen vorliegen.

Niederinjektionsbedingungen bedeuten, dass das Produkt aus maximaler Generationsrate Go und effektiver Lebensdauer der Minoritätsladungsträger sehr klein gegenüber der Dotierkonzentration des Halbleitersubstrates ist. Entsprechend liegen Hochinjektionsbedingungen vor, wenn das Produkt aus maximaler Generationsrate und effektiver Lebensdauer etwa im Bereich der Dotierkonzentration des Halbleitersubstrates liegt. Quasi-statische Messungen unter Niedrig- und Hochinjektionsbedingungen sind an sich bekannt und auch entsprechende Messaufbauten und Parameter zur Erzeugung dieser Injektionsbedingungen sind dem Fachmann bekannt.

In der vorgenannten vorzugsweisen Ausführungsform des erfindungsgemäßen Verfahrens wird - wie zuvor nach Verfahrensschritten A, B und C beschrieben - jeweils die Lebensdauer $\tau_{low}$ bei Niedriginjektionsbedingungen und die Lebensdauer $\tau_{high}$ bei Hochinjektionsbedingungen bestimmt.

Auch in dieser vorzugsweisen Ausführungsform wird der zeitliche Verlauf der Generationsrate quantitativ bestimmt. Bei dem zeitlichen Verlauf der Intensität der Photolumineszenzstrahlung ist abermals eine Bestimmung in relativen Einheiten ausreichend.

Die Dotierkonzentration N des Halbleitersubstrates wird bei dieser vorzugsweisen Ausführungsform abhängig von den vorgenannten Größen bestimmt. Die Bestimmung erfolgt dabei vorzugsweise folgendermaßen: Dadurch, dass die Niederinjektionsbedingung $\Delta n \ll N$ erfüllt ist, reduziert sich Gleichung 6 auf einen linearen Zusammenhang zwischen einem messbaren Lumineszenzsignal und der Überschussladungsträgerdichte:

$$\Phi_{low}(t) = A \cdot N \cdot \Delta n_{low}(t) \qquad (10)$$

Durch die gemäß oben beschriebenen Verfahrensschritten bestimmte Lebensdauer $\tau_{0,low}$ kann bei bekannter maximaler Generationsrate $G_{0,low}$ (mit dem Produkt aus $\tau_{0,low}$ und $G_{0,low}$, das der maximalen Überschussladungsträgerdichte entspricht) nun bei Messung der Intensität der Photolumineszenzstrahlung $\Phi_{low}(t)$ der zunächst unbekannte Faktor $A \cdot N$ bestimmt werden. Mit dem Verhältnis der Verstärkungsfaktoren des Lumineszenzsignals zwischen Hoch- und Niederinjektionsmessung c lässt sich das Lumineszenzsignal unter Hochinjektionsbedingungen dann analog zu Gleichung 6 darstellen als

$$\Phi_{high}(t) = \frac{A}{c} \cdot \Delta n_{high}(t) \cdot \left(\Delta n_{high}(t) + N\right) = \frac{AN}{c} \cdot \Delta n_{high}(t) \cdot \left(\frac{\Delta n_{high}(t)}{N} + 1\right). \tag{11}$$

Mit bekanntem *AN/c* und bekanntem $\tau_{0,high}$ und $G_{0,high}$ (und damit bekannter maximaler Überschussladungsträgerdichte, s.o.) lässt sich bei Messung der Intensität der Photolumineszenzstrahlung $\Phi_{high}(t)$ aus Gleichung 11 die Dotierkonzentration N bestimmen. Die Bestimmung einer injektionsabhängigen Lebensdauer kann dann gemäß der bereits beschriebenen Vorgehensweise unter Verwendung der Kontinuitätsgleichung (Gleichung 4) vorgenommen werden.

Vorzugsweise erfolgt die quantitative Bestimmung des zeitabhängigen Verlaufs der Generationsrate *G(t)* wie folgt: Durch Messung des zeitabhängigen Photostroms einer Photodiode bekannter spektraler Quantenausbeute am Probenort ist die Stromdichte der Anregungsstrahlung jo messbar. Bei bekanntem Spektrum (insb. für Laser: bei bekannter Wellenlänge) der Anregungsstrahlung und bekanntem Absorptionskoeffizient des Halbleitermaterials $\alpha$ kann mit der optischen Reflektivität der Probenoberfläche R bei der Anregungswellenlänge auch die Generationsrate als Funktion der Substrattiefe z bestimmt werden:

$$G(z) = (1 - R)j_0\alpha \exp(-z\alpha) \tag{12}$$

Mittelung über die gesamte Substratdicke liefert den notwendigen Wert für die Generationsrate.

Ein nicht beanspruchtes Verfahren zur Bestimmung von Materialparametern eines dotierten Halbleitersubstrates durch Messung von Photolumineszenzstrahlung basiert auf einer Methode der selbstkonsistenten Kalibrierung, wie in T. Trupke, R.A. Bardos, M.D. Abbott, "Self-Consistent Calibration of Photoluminescence and Photoconductance Lifetime Measurements", Applied Physics Letters, 87: 184102, 2005 beschrieben.

Die Verfahrensschritte A bis C entsprechen hierbei den beschriebenen Verfahrensschritten.

Bei dem Verfahren wird in Verfahrensschritt C die effektive Lebensdauer der Minoritätsladungsträger des Halbleitersubstrates abhängig von der Überschussladungsträgerdichte, $\tau(\Delta n)$, mittels einer Selbstkonsistenzmethode bestimmt und gleichzeig ein Skalierungsparameter A und die Dotierkonzentration N *des* Halbleitersubstrates.

Es ist aus der vorgenannten Veröffentlichung bekannt, dass sich die zeitabhängige Intensität der Photolumineszenzstrahlung $\Phi(t)$ abhängig von der zeitabhängigen Überschussladungsträgerdichte $\Delta n(t)$, der Dotierkonzentration N und einem Skalierungsfaktor A beschreiben lässt. In der vorgenannten Veröffentlichung wird beschrieben, dass bei Kenntnis der Dotierkonzentration N sich der Skalierungsparameter A wie folgt ermitteln lässt:
Für einen inkorrekten Skalierungsfaktor A ergibt sich bei Auftrag der Überschussladungsträgerdichte gegen die effektive Lebensdauer eine so genannte Hysterese-Kurve. Dies ist jedoch ein Artefakt, dass sich in der fehlerhaften Umrechnung zwischen Intensität der Photolumineszenzstrahlung und Überschussladungsträgerdichte aufgrund des fehlerhaften Kalibrierungsfaktors A gründet. Es ist daher möglich, durch Eliminierung des Hubs der Hysterese-Kurve den Skalierungsfaktor A zu bestimmen und hierdurch aus den Messdaten die effektive Lebensdauer der Minoritätsladungsträger in Abhängigkeit der Überschussladungsträgerdichte.

Untersuchungen des Anmelders haben gezeigt, dass sich die Minimierung der Hysterese-Kurve zweidimensional mit zwei freien Parametern durchführen lässt, wobei ein Parameter der vorgenannte Skalierungsfaktor A und der andere Parameter die Dotierkonzentration N des Halbleitersubstrates ist. Auch hier ist es somit möglich, die effektive Lebensdauer in Abhängigkeit der Überschussladungsträgerdichte ohne Kenntnis oder Bestimmung der Dotierkonzentration des Halbleitersubstrates durch eine andere Messmethode zu bestimmen und darüber hinaus ist die Bestimmung der Dotierkonzentration N selbst möglich.

Die Minimierung kann erfolgen, indem eine Fehlerfunktion definiert wird. Jede Überschussladungsträgerdichte unterhalb der maximal Erreichten liegt im Zeitverlauf einer Anregungsperiode zweimal (*up / down*) vor. Zu jedem Wertepaar von Dotierkonzentration N *und* Kalibrierfaktor A lassen sich gemäß der Kontinuitätsgleichung (Gleichung 4) dazu zwei Lebensdauern $\tau_{up}$ und $\tau_{down}$ bestimmen, die bei richtiger Wahl der Parameter N und A identisch sein müssen. Besagte Fehlerfunktion enthält die Summe der Abweichungsquadrate dieser bei diskreten, wohldefinierten Niveaus der Überschussladungsträgerdichte auftretenden Differenzen zwischen den Lebensdauern $\tau_{up}$ und $\tau_{down}$.

$$\chi(N,A) = \sum_i \left( 2 \frac{\tau_{up}(\Delta n_i, N, A) - \tau_{down}(\Delta n_i, N, A)}{\tau_{up}(\Delta n_i, N, A) + \tau_{down}(\Delta n_i, N, A)} \right)^2 \qquad (13)$$

Der Nenner in Gleichung 13 auf der rechten Seite dient dem Zweck, der Berechnung besonders kleiner Fehlerquadratsummen im Falle besonders kleiner Lebensdauern vorzubeugen. Damit wird die Fehlerfunktion einheitenlos. Das globale Minimum der Fehlerfunktion $\chi(A,N)$ offenbart dann die gesuchten Parameter $A$ und $N$ mit denen dann bei gegebener Generationsrate $G(t)$ mithilfe von Gleichungen 4 und 5 gemäß der bereits beschriebenen Vorgehensweise die Lebensdauer als Funktion der Überschussladungsträgerdichte bestimmt werden kann.

Es ist auch denkbar, diesen Algorithmus zur Minimierung einer Fehlerquadratsumme auf mehrere Messungen, etwa bei verschiedenen Anregungsintensitäten (Nieder- vs. Hochinjektion), auszuweiten.

Der Aufbau einer Messvorrichtung zur Durchführung des erfindungsgemäßen Verfahrens und das grundsätzliche Vorgehen bei Durchführung des erfindungsgemäßen Verfahrens erfolgt in an sich bekannter Weise wie bei den vorbekannten QSS-PL-Methoden wie beispielsweise in T. Trupke and R. A. Bardos, 31st IEEE PVSC, Orlando, 2005 und T. Trupke, R.A. Bardos, M.D. Abbott, "Self-Consistent Calibration of Photoluminescence and Photoconductance Lifetime Measurements", Applied Physics Letters, 87: 184102, 2005 beschrieben, wobei die Auswertung der Messdaten jedoch hiervon abweichend wie zuvor beschrieben erfolgt.

Vorzugsweise erfolgt die zeitaufgelöste Messung der Intensität der Lumineszenzstrahlung $\Phi(t)$ indem zeitlich aufeinanderfolgend eine Vielzahl von Messwerten der Intensität der Lumineszenzstrahlung gemessen wird. Vorzugsweise erfolgt die Messung mit einer Taktrate im Bereich zwischen 10-300kHz, je nach Modulationsperiodendauer T (vorzugsweise im Bereich 10Hz$<T^{-1}<$300Hz), die sich nach der zu erwartenden Lebensdauer richtet.

Die Messung des zeitlichen Verlaufs der Generationsrate $G(t)$ erfolgt vorzugsweise derart, indem die Intensität der Anregungsstrahlung analog zur Intensität der Lumineszenzstrahlung gemessen wird, d. h. durch zeitlich aufeinander folgendes Messen einer Vielzahl von Messpunkten für die Intensität der Anregungsstrahlung. Die gemessene Intensität der Anregungsstrahlung entspricht qualitativ dem zeitlichen Verlauf der Intensität der Generationsrate. Hierbei erfolgt vorzugsweise die Messung mit identischer Taktfrequenz zur Messung der Lumineszenzstrahlung.

Die Ermittlung des quantitativen zeitlichen Verlaufs der Generationsrate $G(t)$ erfolgt vorzugsweise in der bereits oben beschriebenen Weise.

Die Modulation der Anregungsstrahlung erfolgt periodisch und vorzugsweise sinusartig. Zur Erhöhung der Messgenauigkeit erfolgt vorzugsweise die Messung der Intensität der Anregungsstrahlung und/oder der Intensität der Photolumineszenzstrahlung über eine Vielzahl von Perioden und anschließend erfolgt eine Mittlung der Messwerte. Vorzugsweise erfolgt die Mittlung über Messwerte von mindestens 100, bevorzugt mindestens 300, insbesondere bevorzugt mindestens 500 Perioden, um ein hinreichend hohes Signal-zu-Rausch-Verhältnis nach Mittelung der Messwerte zu erzielen.

Die Anregungsstrahlung wird vorzugsweise auf eine an sich bekannte Weise erzeugt mittels einer modulierbaren Lichtquelle. Besonders geeignet sind hierfür Laser, ebenso liegt die Verwendung von LED-Lichtquellen im Rahmen der Erfindung.

Die Wellenlänge der Anregungsstrahlung liegt vorzugsweise über der Bandkante des zu vermessenden Halbleitersubstrates bzw. das Spektrum der Anregungsstrahlung liegt vorzugsweise zumindest im Wesentlichen über dieser Bandkante. Das erfindungsgemäße Verfahren ist insbesondere zur Bestimmung von Materialparametern bei Silizium-Halbleitersubstraten geeignet. Vorzugsweise liegt die Wellenlänge bzw. der Schwerpunkt des Spektrums der Anregungsstrahlung daher unter 1000 nm, bevorzugt unter 900 nm. Insbesondere sind Wellenlängen zwischen 790 nm und 880 nm zur Durchführung des erfindungsgemäßen Verfahrens geeignet.

Das Verfahren wird vorzugsweise mittels eines von den QSS-PL-Methoden an sich bekannten Messaufbaus durchgeführt. Vorzugsweise wird die Anregungsstrahlung ausgehend von der Strahlungsquelle, wie beispielsweise einem Laser, über einen Strahlteiler auf das Halbleitersubstrat geleitet, wobei ein Teil der Anregungsstrahlung über den Strahlteiler auf eine Detektionseinheit zur Messung des zeitlichen Verlaufs der Intensität der Anregungsstrahlung geleitet wird. Als Detektionseinheit sind insbesondere Dioden geeignet. Der Strahlteiler ist vorzugsweise derart angeordnet und ausgeführt, dass lediglich ein geringer Teil der Anregungsstrahlung, vorzugsweise weniger als 5 %, bevorzugt weniger als 2 %, insbesondere weniger als 1 % hinsichtlich der Intensität der Anregungsstrahlung auf die Detektionseinheit geleitet wird, so dass der wesentliche Anteil der Anregungsstrahlung hinsichtlich der Intensität auf das Halbleitersubstrat auftrifft zur Erzeugung von Ladungsträgerpaaren.

Die Intensität der Photolumineszenzstrahlung wird bevorzugt in an sich bekannter Weise mittels einer Diode gemessen. Insbesondere ist es vorteilhaft, die Strahlungsquelle und die Detektionseinheit für die Intensität der Photolumineszenzstrahlung auf gegenüber liegenden Seiten des Halbleitersubstrates anzuordnen. Auf diese Weise dient das Halbleitersubstrat selbst bereits als Filter und schirmt die Detektionseinheit für die Intensität der Photolumineszenzstrahlung von der Strahlungsquelle ab, so dass Fehler durch Auftreffen von Anregungsstrahlung auf die Detektionseinheit für die Intensität der Photolumineszenstrahlung vermieden werden. Vorteilhafterweise sind im Strahlengang zwischen Halbleitersubstrat und Detektionseinheit für die Intensität der Photolumineszenstrahlung zusätzliche Filter angebracht zum Ausblenden der Anregungsstrahlung. Solche Filter sind bei Photolumineszenzaufbauten an sich bekannt.

Ebenso liegt es im Rahmen der Erfindung, Strahlungsquelle und Detektionseinheit für die Intensität der Photolumineszenzstrahlung auf der gleichen Seite des Halbleitersubstrates anzuordnen. Hierdurch ist es insbesondere möglich, Halbleiterstrukturen wie Solarzellen, welche auf einer Rückseite eine teilweise oder ganzflächige Metallisierung aufweisen, mittels des erfindungsgemäßen Verfahrens zu vermessen. In diesem Fall ist es zwingend notwendig, im Strahlengang zwischen Halbleitersubstrat und Detektionseinheit für die Intensität der Photolumineszenzstrahlung Filter zum Ausblenden etwaiger reflektierter Anregungsstrahlung anzuordnen. Auch diese Anordnung ist bei Messvorrichtungen zur Messung der Photolumineszenzstrahlung an sich bekannt.

Der Messbereich des Halbleitersubstrates, dessen Photolumineszenzstrahlung gemessen wird, ist durch die Detektionseinheit für die Intensität der Photolumineszenzstrahlung bzw. etwaige optische Elemente (Filter, Linsen, Blenden) im Strahlengang zwischen Halbleitersubstrat und Detektionseinheit definiert. Vorzugsweise stellt der Messbereich lediglich einen Teilbereich des Halbleitersubstrates dar. Typischerweise beträgt die Fläche des auf eine Oberfläche des Halbleitersubstrates projizierten Messbereiches zwischen 0,5 cm$^2$ und 12 cm$^2$, sie ist aber darüber hinaus variabel.

Grundsätzlich kann bereits durch Bestimmen der effektiven Lebensdauer an einem Ort des Halbleitersubstrates eine wichtige Information hinsichtlich der Materialqualität des Halbleitersubstrates erhalten werden. Ebenso liegt es im Rahmen der Erfindung, mittels Raster- oder scannender Messverfahren, beispielsweise durch Verschiebung des Halbleitersubstrates auf einem XY-Tisch eine ortsaufgelöste Vermessung der Materialeigenschaften des Halbleitersubstrates an mehreren Ortspunkten vorzunehmen.

Vorzugsweise erfolgt die periodische Modulation der Anregungsstrahlung derart, dass die Intensität der Anregungsstrahlung in einer Periode genau ein Maximum aufweist.

Weitere vorzugsweise Merkmale und Ausführungsformen des erfindungsgemäßen Verfahrens werden im Folgenden anhand der Figuren und einem Ausführungsbeispiel beschrieben. Dabei zeigt:

Figur 1    einen Aufbau zur Durchführung des erfindungsgemäßen Verfahrens,

Figur 2    Messergebnisse und Fitkurven für die zeitabhängige Generationsrate $G(t)$ und Intensität der Photolumineszenzstrahlung $\Phi(t)$ und

Figur 3    die aus den Messergebnissen ermittelte effektive Lebensdauer $\tau(\Delta n)$.

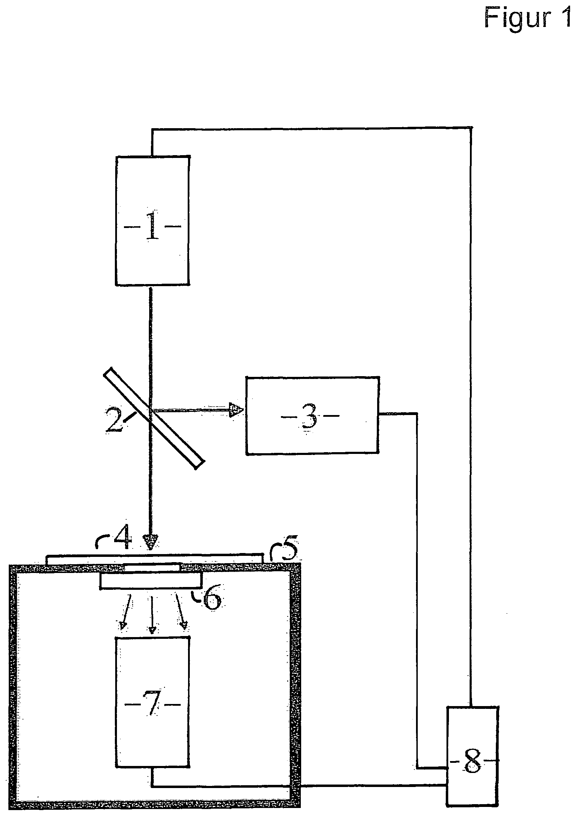

Der in Figur 1 dargestellte Aufbau umfasst eine Strahlungsquelle 1, welche als Dioden-Laser mit einer Wellenlänge von 880 nm ausgebildet ist. Im Strahlengang der Anregungsstrahlung ist ein Strahlteiler 2 angeordnet, mittels dessen etwa 4 % hinsichtlich der Intensität der Anregungsstrahlung auf eine Monitordiode 3 geleitet werden, wohingegen der Hauptteil der Anregungsstrahlung auf ein Halbleitersubstrat 4 in einem Messbereich mit einer Größe von etwa 4 cm$^2$ auftrifft. Das Halbleitersubstrat 4 ist ein multikristalliner Siliziumwafer mit einer Basisdotierung von ~1Ωcm.

Das Halbleitersubstrat ist auf einem Messtisch 5 angeordnet, an dem ein optisches Filter 6 und eine PL-Diode 7 angeordnet ist, zum Messen der Intensität der von dem Messbereich des Halbleitersubstrates 4 ausgehenden Photolumineszenzstrahlung.

Das Filter 6 ist dabei derart ausgebildet, dass Strahlung im Wellenlängenbereich unterhalb von 970 nm ausgeblendet wird.

Strahlenquelle 1, Monitordiode 3 und PL-Diode 7 sind an eine als Computer ausgebildete Steuer- und Auswerteeinheit 8 angeschlossen.

Zur Durchführung eines Ausführungsbeispiels des erfindungsgemäßen Verfahrens wird das Halbleitersubstrat 4 mit periodisch modulierter Anregungsstrahlung der Strahlungsquelle 1 beaufschlagt. Die Modulation erfolgt dabei sinusförmig. Die Intensität der Anregungsstrahlung auf dem Halbleitersubstrat beträgt etwa typischerweise $10^{16}$-$10^{19}$cm$^{-2}$s$^{-1}$.

Mittels der Monitordiode 3 wird qualitativ der zeitliche Verlauf der Intensität der Anregungsstrahlung gemessen, wobei die Messung mit einer Taktrate von typischerweise ~10-300 kHz erfolgt.

Mittels der PL-Diode 7 wird der zeitliche Verlauf der Intensität der Photolumineszenzstrahlung qualitativ gemessen, wobei die Messung mit gleicher Taktrate erfolgt wie im Falle der Anregungsstrahlung.

Es werden Messreihen über 500 Anregungsperioden aufgenommen und die entsprechenden einzelnen Messwerte gemittelt.

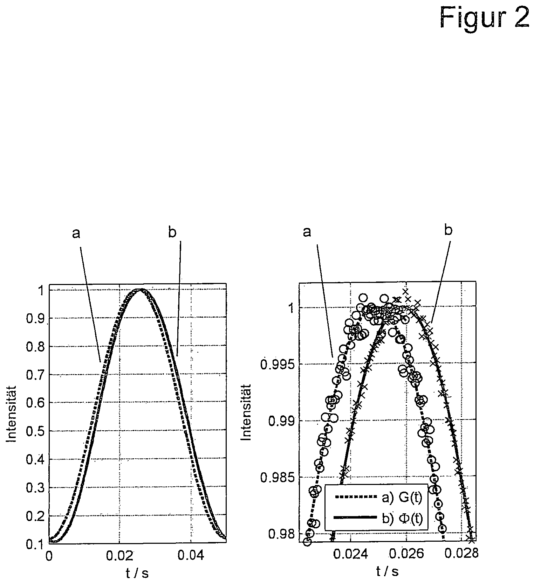

Die Ergebnisse einer solchen Messung sind in Figur 2 dargestellt.

Da es sich um qualitative Messungen handelt, sind auf der y-Achse lediglich auf den Wert 1 normierte Einheiten dargestellt, die x-Achse zeigt hingegen quantitativ den zeitlichen Verlauf in Sekunden an.

Die zu der Kurve *a* gehörenden Messpunkte sind die aus den Messungen der Monitordiode 3 stammenden Messergebnisse und die zu der Kurve b gehörenden Messpunkte die aus den Messungen der PL-Diode 7 stammenden Messdaten.

Die durchgezogenen Linien stellen Fitkurven an die jeweiligen Messpunkte dar, wobei der Fit auf einer sinusartigen Funktion der Amplitude 1 mit den beiden freien Parametern einer Zeit maximaler Intensität $t_0$ (respektive $t_{max}$) und einer Frequenz basiert:

$$f(t) = \cos^2\left(\omega\left(t - t_0\right)\right). \qquad (14)$$

Deutlich ist in Figur 2 der zeitliche Versatz der Maxima der beiden Kurven zu erkennen.

Zur Auswertung werden die zeitlichen Verschiebungen der Maxima der Generationsrate $G(t)$ (Kurve a) zu den Maxima der Intensität der Lumineszenzstrahlung $\Phi(t)$ (Kurve b) bei jeweils geringfügig unterschiedlichen Anregungsintensitäten herangezogen. Dazu wird das zuvor beschriebene Iterationsverfahren unter Verwendung der numerischen Lösung der die Ladungsträgerdynamik beschreibenden Differentialgleichung (Gleichung 4) angewandt.

Bei einer Überschussladungsträgerdichte von $\Delta n \approx 5{,}5 \cdot 10^{15} cm^{-3}$ beträgt die ermittelte Lebensdauer $\tau \approx 1{,}3 \cdot 10^{-3} s$.

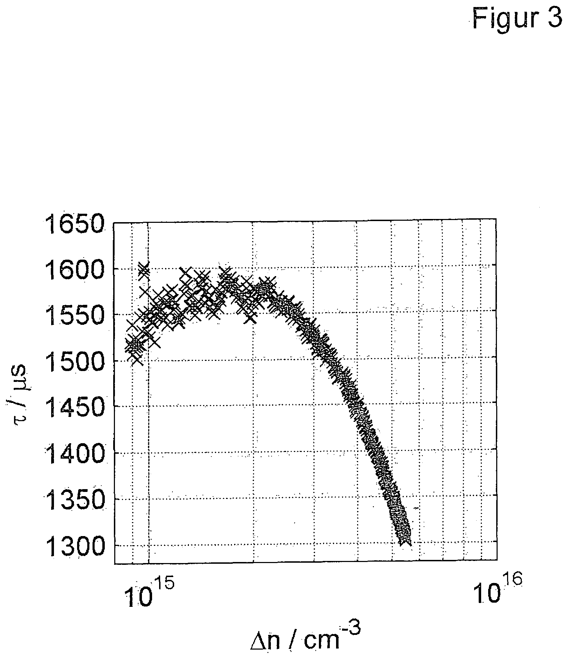

Die daraus über das Verhältnis der Krümmungen der relativen Generationrate sowie der relativen Intensität der Photolumineszenzstrahlung an deren jeweiligen Maxima mittels Gleichung 9 bestimmte Dotierkonzentration beträgt $N \approx 1{,}2 \cdot 10^{16} cm^{-3}$. Unter Verwendung von Gleichung 4 kann damit (wie in Figur 3 abgebildet) die Lebensdauer als Funktion der Überschussladungsträgerdichte bestimmt werden.

Mit dem erfindungsgemäßen Verfahren ist es somit erstmals möglich, durch Auswertung der Photolumineszenzstrahlung eines Halbleitersubstrates die effektive Lebensdauer bei einem beliebigen Injektionsniveau zu bestimmen, ohne dass dafür die Kenntnis der Dotierkonzentration des Halbleitersubstrates N notwendig ist. Zusätzlich lässt sich N des Halbleitersubstrates selbst bestimmen.

**Patentansprüche**

1. Verfahren zur Bestimmung einer effektiven Lebensdauer $\tau$ der Minoritätsladungsträger eines dotierten Halbleitersubstrates durch Messung von Photolumineszenzstrahlung bei quasi-statischen Messbedingungen, folgende Verfahrensschritte umfassend:

   A Beaufschlagen des Halbleitersubstrates mit elektromagnetischer Anregungsstrahlung zum Erzeugen von Photolumineszenzstrahlung in dem Halbleitersubstrat, wobei der zeitliche Verlauf der Intensität der Anregungsstrahlung periodisch moduliert ist, derart, dass die Generationsrate $G$ von Ladungsträgerpaaren in dem Halbleitersubstrat (4) aufgrund der Anregungsstrahlung während einer Anregungsperiode ein Maximum und ein Minimum aufweist und wobei zumindest der relative zeitliche Verlauf der Generationsrate $G(t)$ mittels zeitabhängiger Messung der Intensität der Anregungsstrahlung bestimmt wird,
   B Zeitaufgelöstes Messen der Intensität der von einem Messbereich des Halbleitersubstrates ausgehenden Photolumineszenzstrahlung, wobei der zeitliche Verlauf der Intensität der Photolumineszenzstrahlung $\Phi(t)$ zumindest während einer Anregungsperiode gemessen wird,
   C Bestimmen der effektiven Lebensdauer $\tau$ des Halbleitersubstrates auf der Basis der Messung des Zeitversatzes zwischen dem Maximum der Generationsrate $G(t)$ und der Intensität der Photolumineszenzstrahlung $\Phi(t)$, wobei die Verfahrensschritte A und B bezüglich der Anregungsintensität in einer ersten Messkonfiguration durchgeführt werden, die derart gewählt ist, dass Niederinjektionsbedingungen in dem Halbleitersubstrat vorliegen, und in Schritt C die effektive Lebensdauer $\tau$ der Minoritätsladungsträger bei der während einer Anregungsperiode maximal erreichten Überschussladungsträgerdichte $\Delta n_{max}$ ermittelt wird.

2. Verfahren zur Bestimmung einer effektiven Lebensdauer $\tau$ der Minoritätsladungsträger eines dotierten Halbleitersubstrates durch Messung von Photolumineszenzstrahlung bei quasi-statischen Messbedingungen, folgende Verfahrensschritte umfassend:

   A Beaufschlagen des Halbleitersubstrates mit elektromagnetischer Anregungsstrahlung zum Erzeugen von Photolumineszenzstrahlung in dem Halbleitersubstrat, wobei der zeitliche Verlauf der Intensität der Anregungsstrahlung periodisch moduliert ist, derart, dass die Generationsrate G von Ladungsträgerpaaren in dem Halbleitersubstrat (4) aufgrund der Anregungsstrahlung während einer Anregungsperiode ein Maximum und ein Minimum aufweist und wobei der zeitliche Verlauf der Generationsrate $G(t)$ mittels zeitabhängiger Messung der Intensität der Anregungsstrahlung bestimmt wird,

B Zeitaufgelöstes Messen der Intensität der von einem Messbereich des Halbleitersubstrates ausgehenden Photolumineszenzstrahlung, wobei der zeitliche Verlauf der Intensität der Photolumineszenzstrahlung $\Phi(t)$ zumindest während einer Anregungsperiode gemessen wird,

C Bestimmen der effektiven Lebensdauer $\tau$ der Minoritätsladungsträger des Halbleitersubstrates über ein Iterationsverfahren auf der Basis der Messung des Zeitversatzes zwischen den Maxima von Generationsrate $G(t)$ und Intensität der Photolumineszenzstrahlung $\Phi(t)$, wobei die Verfahrensschritte A und B bezüglich der Anregungsintensität in einer zweiten Messkonfiguration durchgeführt werden, die derart gewählt ist, dass Hochinjektionsbedingungen in dem Halbleitersubstrat vorliegen, und eine mindestens zweimalige Ausführung der Verfahrensschritte A und B erfolgt, wobei sich die erste und die zweite Ausführung hinsichtlich der maximalen Anregungsintensitäten unterscheiden, und in Schritt C die effektive Lebensdauer $\tau$ des Halbleitersubstrates bei der während einer Anregungsperiode maximal erreichten Überschussladungsträgerdichte $\Delta n_{max}$ ermittelt wird, und wobei die Zeitversätze der jeweiligen Maxima der Generationsrate und Intensität bei den verschiedenen Anregungsbedingungen verwendet werden.

3. Verfahren nach einem der vorangegangenen Ansprüche 1 oder 2,
**dadurch gekennzeichnet,**
**dass** die effektive Lebensdauer $\tau(\Delta n)$ des Halbleitersubstrates in Abhängigkeit der Überschussladungsträgerdichte $\Delta n$ und/oder die Dotierkonzentration $N$ des Halbleitersubstrates bestimmt wird.

4. Verfahren nach einem der vorangegangenen Ansprüche 1 oder 2, **dadurch gekennzeichnet,**

**dass** der zeitliche Verlauf der Generationsrate mittels eines mathematischen Modells, welches einen ersten Satz von jeweils mindestens zwei Fitparametern aufweist, beschrieben wird und der zeitliche Verlauf der Intensität der Photolumineszenzstrahlung mittels eines analogen mathematischen Modells, welches einen zweiten Satz von jeweils mindestens zwei Fitparametern aufweist, beschrieben wird, und die Fitparamter des ersten Satzes abhängig von den zeitabhängig gemessenen Intensitäten der Anregungsstrahlung und die Fitparamter des zweiten Satzes abhängig von den zeitabhängig gemessenen Intensitäten der Photolumineszenzstrahlung bestimmt werden, und
**dass** die effektive Lebensdauer $\tau$ des Halbleitersubstrates in Abhängigkeit der Überschussladungsträgerdichte $\Delta n$ und/oder die Dotierkonzentration $N$ des Halbleitersubstrates abhängig von dem ersten und zweiten Satz Fitparameter bestimmt werden.

5. Verfahren nach Anspruch 4,
**dadurch gekennzeichnet,**
**dass** die Modulation der Anregungsstrahlung sinusförmig ist und das mathematische Modell für die zeitlichen Verläufe der Generationsrate und der Intensitäten der Photolumineszenzstrahlung jeweils eine sinusartige Funktion und jeweils als Fitparamter eine Frequenz und eine Phasenlage aufweisen.

6. Verfahren nach einem der Ansprüche 3 bis 5,
**dadurch gekennzeichnet,**
**dass** die Anregungsstrahlung derart moduliert wird, dass die Überschussladungsträgerdichte der Minoritätsladungsträger in dem Halbleitersubstrat (4) bei maximaler Generation in etwa der zu erwartenden Dotierkonzentration des Halbleitersubstrates entspricht.

7. Verfahren nach Anspruch 1 oder 2,
**dadurch gekennzeichnet,**
**dass** die Dotierkonzentration N des Halbleitersubstrates bestimmt wird.

## Claims

1. Method for determining an effective lifetime $\tau$ of the minority charge carriers of a doped semiconductor substrate by measurement of photoluminescent radiation under quasi-static measurement conditions, comprising the following method steps:

A application of electromagnetic excitation radiation to the semiconductor substrate in order to generate photoluminescent radiation in the semiconductor substrate, the variation in the intensity of the excitation radiation over time being periodically modulated in such a way that the generation rate G of charge carrier pairs in the semiconductor substrate (4) as a result of the excitation radiation has a maximum and a minimum during an excitation period and at least the relative variation in the generation rate over time $G(t)$ being determined by means of time-dependent measurement of the intensity of the excitation radiation,

B time-resolved measurement of the intensity of the photoluminescent radiation emanating from a measurement region of the semiconductor substrate, the variation in the intensity of the photoluminescent radiation over time $\Phi(t)$ being measured at least during an excitation period,

C determination of the effective lifetime $\tau$ of the semiconductor substrate on the basis of the measurement of the time difference between the maximum of the generation rate $G(t)$ and the maximum of the intensity of the photoluminescent radiation $\Phi(t)$,

wherein the method steps A and B are executed, in respect of the excitation intensity, in a first measurement configuration which is selected in such a way that low-injection conditions are present in the semiconductor substrate, and

in step C the effective lifetime $\tau$ of the minority charge carriers at the maximum excess charge carrier density $\Delta n_{max}$ achieved during an excitation period is determined.

2. Method for determining an effective lifetime $\tau$ of the minority charge carriers of a doped semiconductor substrate by measurement of photoluminescent radiation under quasi-static measurement conditions, comprising the following method steps:

A application of electromagnetic excitation radiation to the semiconductor substrate in order to generate photoluminescent radiation in the semiconductor substrate, the variation in the intensity of the excitation radiation over time being periodically modulated in such a way that the generation rate G of charge carrier pairs in the semiconductor substrate (4) as a result of the excitation radiation has a maximum and a minimum during an excitation period and the variation in the generation rate over time $G(t)$ being determined by means of time-dependent measurement of the intensity of the excitation radiation,

B time-resolved measurement of the intensity of the photoluminescent radiation emanating from a measurement region of the semiconductor substrate, the variation in the intensity of the photoluminescent radiation over time $\Phi(t)$ being measured at least during an excitation period,

C determination of the effective lifetime $\tau$ of the minority charge carriers of the semiconductor substrate by means of an iteration process on the basis of the measurement of the time difference between the maxima of generation rate $G(t)$ and intensity of the photoluminescent radiation $\Phi(t)$,

wherein the method steps A and B are executed, in respect of the excitation intensity, in a second measurement configuration which is selected in such a way that high-injection conditions are present in the semiconductor substrate, and method steps A and B are executed at least twice, the first and second executions differing in respect of the maximum excitation intensities, and

in step C the effective lifetime $\tau$ of the semiconductor substrate at the maximum excess charge carrier density $\Delta n_{max}$ achieved during an excitation period is determined, and wherein the time differences between the respective maxima of the generation rate and intensity under the different excitation conditions are used.

3. Method according to either one of preceding claims 1 and 2,
   **characterised in that**
   the effective lifetime $\tau(\Delta n)$ of the semiconductor substrate in dependence upon the excess charge carrier density $\Delta n$ is determined and/or the doping concentration N of the semiconductor substrate is determined.

4. Method according to either one of preceding claims 1 and 2,
   **characterised in that**
   the variation in the generation rate over time is described by means of a mathematical model which has a first set of at least two fit parameters, and the variation in the intensity of the photoluminescent radiation over time is described by means of an analogous mathematical model which has a second set of at least two fit parameters, and the fit parameters of the first set are determined in dependence upon the time-dependently measured intensities of the excitation radiation and the fit parameters of the second set are determined in dependence upon the time-dependently measured intensities of the photoluminescent radiation; and the effective lifetime $\tau$ of the semiconductor substrate in dependence upon the excess charge carrier density $\Delta n$ is determined and/or the doping concentration N of the semiconductor substrate in dependence upon the first and second set of fit parameters is determined.

5. Method according to claim 4,

**characterised in that**
the modulation of the excitation radiation is sinusoidal and the mathematical model for the variations in the generation rate and the intensities of the photoluminescent radiation over time has in each case a sinusoidal function and in each case a frequency and a phase position as fit parameters.

6. Method according to any one of claims 3 to 5,
**characterised in that**
the excitation radiation is modulated in such a way that the excess charge carrier density of the minority charge carriers in the semiconductor substrate (4) at maximum generation corresponds approximately to the expected doping concentration of the semiconductor substrate.

7. Method according to claim 1 or 2,
**characterised in that**
the doping concentration N of the semiconductor substrate is determined.

**Revendications**

1. Procédé pour déterminer une durée de vie effective $\tau$ des porteurs de charge minoritaires d'un substrat semi-conducteur dopé par mesure d'un rayonnement photoluminescent dans des conditions de mesure quasi-statiques, comprenant les étapes de procédé suivantes :

   A appliquer au substrat semi-conducteur un rayonnement d'excitation électromagnétique pour produire un rayonnement photoluminescent dans le substrat semi-conducteur, dans lequel la courbe dans le temps de l'intensité du rayonnement d'excitation est modulée périodiquement, de telle sorte que le taux de production G de paires de porteurs de charge dans le substrat semi-conducteur (4) présente un maximum et un minimum en raison du rayonnement d'excitation pendant une période d'excitation et dans lequel au moins la courbe dans le temps relative du taux de production $G(t)$ est déterminée à l'aide d'une mesure en fonction du temps de l'intensité du rayonnement d'excitation,
   B mesurer dans le temps l'intensité du rayonnement photoluminescent partant d'une zone de mesure du substrat semi-conducteur, dans lequel la courbe dans le temps de l'intensité du rayonnement photoluminescent $\Phi(t)$ est mesurée au moins pendant une période d'excitation,
   C déterminer la durée de vie effective $\tau$ du substrat semi-conducteur sur la base de la mesure du décalage dans le temps entre le maximum du taux de production $G(t)$ et l'intensité du rayonnement photoluminescent $\Phi(t)$,

   dans lequel les étapes de procédé A et B sont réalisées par rapport à l'intensité d'excitation dans une première configuration de mesure qui est choisie de telle sorte qu'il y ait des conditions d'injection basse dans le substrat semi-conducteur, et dans l'étape C la durée de vie effective $\tau$ des porteurs de charge minoritaires est établie lors de la densité de porteurs de charge en excès maximale $\Delta n_{max}$ atteinte pendant une période d'excitation.

2. Procédé pour déterminer une durée de vie effective $\tau$ des porteurs de charge minoritaires d'un substrat semi-conducteur dopé par mesure d'un rayonnement photoluminescent dans des conditions de mesure quasi-statiques, comprenant les étapes de procédé suivantes :

   A appliquer au substrat semi-conducteur un rayonnement d'excitation électromagnétique pour produire un rayonnement photoluminescent dans le substrat semi-conducteur, dans lequel la courbe dans le temps de l'intensité du rayonnement d'excitation est modulée périodiquement, de telle sorte que le taux de production G de paires de porteurs de charge dans le substrat semi-conducteur (4) présente un maximum et un minimum en raison du rayonnement d'excitation pendant une période d'excitation et dans lequel au moins la courbe dans le temps du taux de production $G(t)$ est déterminée à l'aide d'une mesure en fonction du temps de l'intensité du rayonnement d'excitation,
   B mesurer dans le temps l'intensité du rayonnement photoluminescent partant d'une zone de mesure du substrat semi-conducteur, dans lequel la courbe dans le temps de l'intensité du rayonnement photoluminescent $\Phi(t)$ est mesurée au moins pendant une période d'excitation,
   C déterminer la durée de vie effective $\tau$ des porteurs de charge minoritaires du substrat semi-conducteur par un procédé d'itération sur la base de la mesure du décalage dans le temps entre les maxima de taux de production $G(t)$ et l'intensité du rayonnement photoluminescent $\Phi(t)$,

dans lequel les étapes de procédé A et B sont réalisées par rapport à l'intensité d'excitation dans une deuxième configuration de mesure qui est choisie de telle sorte qu'il y ait des conditions d'injection élevée dans le substrat semi-conducteur, et les étapes de procédé A et B sont réalisées au moins deux fois, dans lequel les première et deuxième réalisations se différencient par les intensités d'excitation maximales, et dans l'étape C, la durée de vie effective $\tau$ du substrat semi-conducteur est établie lors de la densité de porteurs de charge en excès maximale $\Delta n_{max}$ atteinte pendant une période d'excitation, et dans lequel les décalages dans le temps des maxima respectifs du taux de production et de l'intensité dans les différentes conditions d'excitation sont utilisés.

3. Procédé selon l'une des revendications 1 ou 2 précédentes,
   **caractérisé**
   **en ce que** la durée de vie effective $\tau(\Delta_n)$ du substrat semi-conducteur est déterminée en fonction de la densité de porteurs de charge en excès $\Delta n$ et/ou la concentration de dopage N du substrat semi-conducteur.

4. Procédé selon l'une des revendications 1 ou 2 précédentes,
   **caractérisé**

   **en ce que** la courbe dans le temps du taux de production est décrite à l'aide d'un modèle mathématique qui présente un premier ensemble de respectivement au moins deux paramètres d'ajustement et la courbe dans le temps de l'intensité du rayonnement photoluminescent est décrite à l'aide d'un modèle mathématique analogue qui présente un deuxième ensemble de respectivement au moins deux paramètres d'ajustement, et les paramètres d'ajustement du premier ensemble sont déterminés en fonction des intensités du rayonnement d'excitation mesurées en fonction du temps et les paramètres d'ajustement du deuxième ensemble sont déterminés en fonction des intensités du rayonnement photoluminescent mesurées en fonction du temps, et
   **en ce que** la durée de vie effective $\tau$ du substrat semi-conducteur est déterminée en fonction de la densité de porteurs de charge en excès $\Delta n$ et/ou la concentration de dopage N du substrat semi-conducteur est déterminée en fonction des premier et deuxième ensembles de paramètres d'ajustement.

5. Procédé selon la revendication 4,
   **caractérisé**
   **en ce que** la modulation du rayonnement d'excitation est sinusoïdale et le modèle mathématique pour les courbes dans le temps du taux de production et des intensités du rayonnement photoluminescent présente respectivement une fonction sinusoïdale et respectivement comme paramètres d'ajustement une fréquence et une position de phase.

6. Procédé selon l'une des revendications 3 à 5,
   **caractérisé**
   **en ce que** le rayonnement d'excitation est modulé de telle sorte que la densité de porteurs de charge en excès des porteurs de charge minoritaires dans le substrat semi-conducteur (4) avec une production maximale correspond à peu près à la concentration de dopage du substrat semi-conducteur à prévoir.

7. Procédé selon la revendication 1 ou 2,
   **caractérisé**
   **en ce que** la concentration de dopage N du substrat semi-conducteur est déterminée.

Figur 1

# Figur 2

Figur 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2008052237 A

**In der Beschreibung aufgeführte Nicht-Patentliteratur**

- **WÜRFEL, P. et al.** Diffusions lengths of silicon solar cells from luminescence images. *Journal of Applied Physics,* 2007, vol. 101, 123110
- **TRUPKE, T. et al.** Photoluminescence imaging of silicon wafers. *Applied Physics Letters,* 2006, vol. 89, 044107
- **T. TRUPKE ; R. A. BARDOS.** *31 st IEEE PVSC, Orlando,* 2005
- **T. TRUPKE ; R.A. BARDOS ; M.D. ABBOTT.** Self-Consistent Calibration of Photoluminescence and Photoconductance Lifetime Measurements. *Applied Physics Letters,* 2005, vol. 87, 184102

- **SINTON, R. et al.** Quasi-Steady-State Photoconductance, a new method for solar cell material and device characterization. *25th IEEE PVSC, Washington D.C.,* 1996
- **CUEVAS, A.** The paradox of compensated silicon. *COMMAD IUMRS-ICEM08, Sydney,* 2008
- **BRUGGEMANN R et al.** *Modulated photoluminescence studies for lifetime determination in amorphous-silicon passivated crystalline-silicon wafers*
- **T. TRUPKE ; R. A. BARDOS.** *31st IEEE PVSC, Orlando,* 2005